# EUROPEAN PATENT APPLICATION

(11) **EP 4 783 773 A1**
(43) Date of publication of application: **29.07.2026**
(21) Application number: 26151553.0
(22) Date of filing: 13.01.2026
(51) Int. Cl.: H10D 86/40, H10D 30/67

(54) **DISPLAY DEVICE**

(30) Priority: 24.01.2025 KR 20250011984
(71) Applicant: LG Display Co., Ltd., Seoul 150-721 (KR)
(72) Inventor: NOH, Sang Soon, Paju-si, Gyeonggi-do (KR); MOON, Tae Hyoung, Paju-si, Gyeonggi-do (KR)
(74) Representative: Viering, Jentschura & Partner mbB Patent- und Rechtsanwälte

(57) **Abstract**

Disclosed is a display device including a substrate (110) on which a first subpixel (SP1) and a second subpixel (SP2) are disposed, a first driving transistor (T2_SP1) at the first subpixel (SP1), the first driving transistor (T2_SP1) comprising a first active layer (152), a first gate electrode (146) under the first active layer (152), a lower insulating layer (126) between the first active layer (152) and the first gate electrode (146), and first and second cover electrodes (166, 167) to cover upper and side portions of both edges of the first active layer (152), and a second driving transistor (T2_SP2) at the second subpixel (SP2), the second driving transistor (T2_SP2) comprising a second active layer (153), a second gate electrode (170) above the second active layer (153), an upper insulating layer (127) between the second active layer (153) and the second gate electrode (170). The second subpixel (SP2) may emit green light, and the first subpixel (SP1) may emit light of a color different from the green light.

## Description

### BACKGROUND OF THE DISCLOSURE

### Field of the Disclosure

The present disclosure relates to a display device including a transistor.

### Discussion of the Related Art

Display devices for displaying images on TVs, monitors, smartphones, tablet computers, and laptop computers, etc. are used in various ways and forms.

A display device includes a display panel having a plurality of light emitting devices or liquid crystals for implementing an image and a transistor for controlling the operation of each of the light emitting devices or the liquid crystals, and displays an image through the plurality of light emitting devices or liquid crystals.

The display device includes a plurality of pixels each including a light emitting device, and is provided with a plurality of driving and switching elements for driving and controlling the light emitting device provided in each of the pixels. The driving and switching elements may be constituted by transistors.

In recent years, various research and development efforts have been made to improve the performance and reliability of transistors.

### SUMMARY OF THE DISCLOSURE

Embodiments of the present disclosure provide a display device including driving transistors corresponding to the light emitting characteristics of subpixels.

Embodiments of the present disclosure provide a display device in which optical reliability of transistors provided in subpixels is improved, whereby the lifespan of the display device is increased.

Embodiments of the present disclosure provide a display device in which the dimensions of transistors of subpixels are unified, whereby it is possible to obtain a stable device in a highly mass-producible structure.

Embodiments of the present disclosure provide a display device in which reliability of transistors is improved to reduce the defect rate and ESG (environmental/social/governance) goals are achieved by reducing production energy through process optimization. According to an aspect of the present disclosure, a display device according to claim 1 is provided. Further embodiments of the display device are described in the dependent claims.

A display device according to an embodiment of the present disclosure includes a substrate on which a first subpixel and a second subpixel are disposed, a first driving transistor at the first subpixel, the first driving transistor comprising a first active layer, a first gate electrode under the first active layer, a lower insulating layer between the first active layer and the first gate electrode, and first and second cover electrodes to cover upper and side portions of both edges of the first active layer, and a second driving transistor at the second subpixel, the second driving transistor comprising a second active layer, a second gate electrode above the second active layer, and an upper insulating layer between the second active layer and the second gate electrode. The second subpixel may emit green light, and the first subpixel may emit light of a color different from the green light.

### BRIEF DESCRIPTION OF THE DRAWINGS

The accompanying drawings, which are included to provide a further understanding of the present disclosure and are incorporated in and constitute a part of this application, illustrate embodiment(s) of the present disclosure and together with the description serve to explain the principle of the present disclosure. In the drawings:
FIG. 1 is a plan view schematically showing a display device according to an embodiment of the present disclosure;
FIG. 2 is a plan view of an embodiment of part A of FIG. 1;
FIG. 3 is a circuit diagram of a subpixel of the display device according to the embodiment of the present disclosure;
FIG. 4 is a plan view of driving transistors of first to third subpixels of FIG. 2;
FIG. 5 is a sectional view taken along line I-I', line II-II', and line III-III' of FIG. 4;
FIG. 6 is an embodiment of a sectional view of a first subpixel;
FIG. 7 is an embodiment of a sectional view of a second subpixel;
FIG. 8 is an embodiment of a sectional view of a third subpixel;
FIG. 9 is a sectional view showing transistors having different stack structures and a storage capacitor in the display device according to the embodiment of the present disclosure; and
FIG. 10 is a sectional view showing the display device according to the embodiment of the present disclosure.

### DETAILED DESCRIPTION OF THE DISCLOSURE

Advantages and features of the disclosure, and implementation methods thereof, will be clarified through the following embodiments described with reference to the accompanying drawings. However, the disclosure may be embodied in different forms and should not be construed as limited to the embodiments set forth herein. Rather, these embodiments are provided so that the disclosure will be thorough and complete, and will fully convey the scope of the disclosure to those skilled in the art. Further, the disclosure is defined only by the categories of the claims.

The same reference numerals designate the same constituent elements. Thicknesses, ratios, and dimensions of constituent elements may be exaggeratedly expressed in the drawings, for effective description of the technical content. In addition, the dimensions and scales of constituent elements shown in the drawings are different from actual dimensions and scales, for convenience of description and, as such, the dimension scales of constituent elements are not limited to those shown in the drawings.

It will be understood that, when one constituent element (or an area, a layer, a portion, or the like) is referred to as being "disposed on", "connected to" or "coupled to" another constituent element, the one constituent element may be directly connected/coupled to the other constituent element, or a third constituent element may be disposed between the two constituent elements.

The term "and/or" is used to include one or more combinations of associated configurations.

It will be understood that, although the terms "first", "second", etc. may be used herein to describe various elements, these elements should not be limited by these terms. These terms are only used to distinguish one element from another. For example, a first element referred to in the following description may represent a second element, without departing from the scope of the disclosure. Similarly, the second element may represent the first element. Unless clearly used otherwise, singular expressions include a plural meaning.

Terms such as "below," "lower," "above," and "upper" are used to describe the relationships between the components shown in the drawings. These terms are relative concepts and are explained based on the orientations indicated in the drawings. For instance, unless "directly" or "immediately" is used, one or more other components may be disposed between two parts. Spatially relative terms such as "below", "beneath", "lower," "above," and "upper" may be employed to easily describe the correlation between one device or component and other devices or components, as represented in the drawings. These spatially relative terms should be understood as encompassing different orientations of the devices when used or during operation, in addition to the directions shown in the drawings. For example, if the device in one of the drawings is turned over, elements described as "below" or "beneath" other elements would then be oriented "above" the other elements. Therefore, the exemplary term "below" may encompass both downward and upward directions.

In this specification, it is to be understood that a term, such as "include" or "have", is intended to designate that a characteristic, a number, a step, an operation, an element, a part or a combination of them described in the specification is present, and does not preclude the presence or addition possibility of one or more other characteristics, numbers, steps, operations, elements, parts, or combinations thereof.

Features of various embodiments of the present disclosure can be partially or overall coupled to or combined with each other, and can be variously inter-operated with each other and driven technically as those skilled in the art can sufficiently understand. The embodiments of the present disclosure can be carried out independently from each other, or can be carried out together in a co-dependent relationship.

Hereinafter, a detailed description will be given of a display device according to embodiments of the present disclosure in conjunction with the attached drawings.

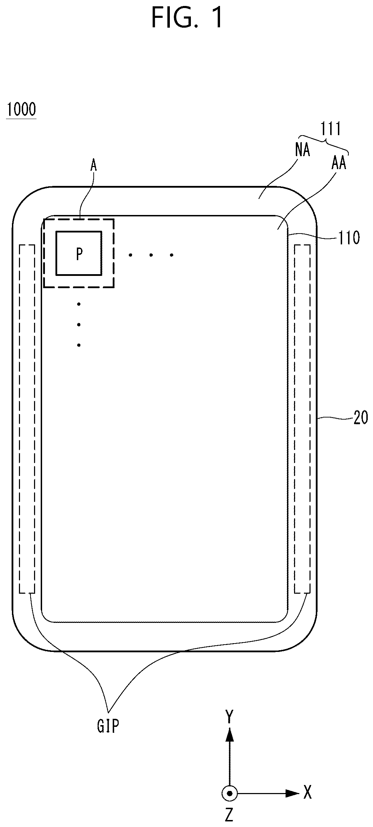

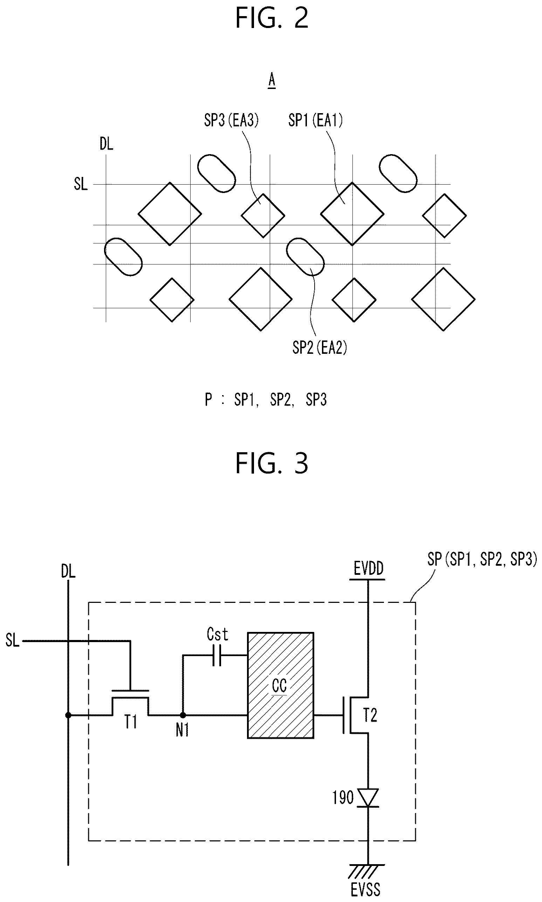

FIG. 1 is a plan view schematically showing a display device according to one or more example embodiments of the present disclosure, and FIG. 2 is a plan view of an example embodiment of part A of FIG. 1. FIG. 3 is a circuit diagram of a subpixel of the display device according to the embodiment of the present disclosure.

Referring to FIGs. 1 and 2, the display device 1000 according to the embodiment of the present disclosure includes a display panel 111 including an active area AA and a non-active area NA and a cover member 20 disposed on the display panel 111.

The cover member 20 may be disposed on the display panel 111 so as to cover a front surface of the display panel 111 and may protect the display panel 111 from external impact. An edge portion of the cover member 20 may have a curvature portion or a curved surface portion bent in a direction (-Z axis direction) toward a rear surface of the display device 1000. As a result, the cover member 20 may be disposed so as to cover a side surface area of the display panel 111 disposed on the rear surface, whereby the display panel 111 may be protected from external impact at not only the front surface but also the side surface of the display device 1000.

The active area AA of the display device 1000 may be an area for displaying an image, and an area other than the active area AA may be referred to as the non-active area NA. The active area AA and the non-active area NA of the display device 1000 may be equally applied to the display panel 111.

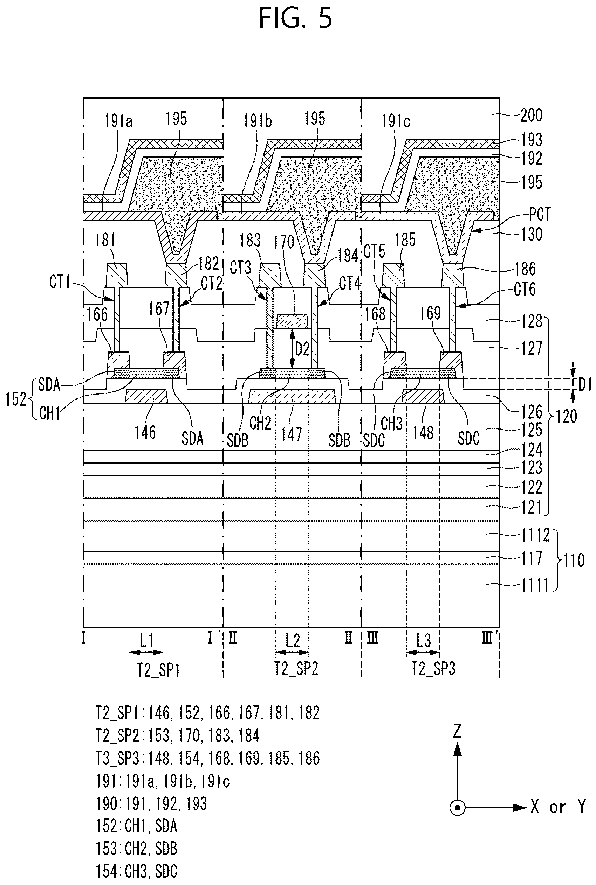

The display device 1000 includes a substrate 110 (see FIG. 5 and subsequent figures) having both the active area AA and the non-active area NA. The division of the active area AA may be equally applied to the substrate 110.

As shown in FIG. 2, a plurality of data lines DL extending in a first direction and a plurality of scan lines SL extending in a second direction intersecting the first direction may be disposed at the active area AA on the substrate 110.

The areas delimited by the intersection of the data lines DL and the scan lines SL may constitute subpixels SP1, SP2, and SP3. Each of the subpixels SP1, SP2, and SP3 may be defined as the area in which an emissive area is disposed. The subpixels SP1, SP2, and SP3 are not limited to the areas delimited by the intersection of the data lines DL and the scan lines SL.

The plurality of scan lines SL disposed at the active area AA may be connected to a drive circuit of a gate-in-panel GIP provided in the non-active area NA so as to sequentially receive gate voltage.

FIG. 2 shows area A corresponding to a part of the active area AA of FIG. 1, wherein a first subpixel SP1, a second subpixel SP2, and a third subpixel SP3 may be implemented so as to emit lights of different colors. The first to third subpixels SP1, SP2, and SP3 may be referred to as a unit pixel P.

For example, the first subpixel SP1, the second subpixel SP2, and the third subpixel SP3 may emit lights of longer wavelengths in that order. The second subpixel SP2 emits light of a medium wavelength, which is a visible light wavelength. For example, the second subpixel SP2 may emit green light. The first subpixel SP1 may emit lights of a shorter wavelength than the green light, and the third subpixel SP3 may emit lights of a longer wavelength than the green light.

For example, the first subpixel SP1 may display blue (B), the second subpixel SP2 may display green (G), and the third subpixel SP3 may display red (R).

The first subpixel SP1 may have a first emissive area EA1, the second subpixel SP2 may have a second emissive area EA2, and the third subpixel SP3 may have a third emissive area EA3. The first emissive area EA1 may emit blue (B), the second emissive area EA2 may emit green (G), and the third emissive area EA3 may emit red (R).

The active area AA may include an area where a camera or a sensor is located.

The first subpixel SP1, the second subpixel SP2, and the third subpixel SP3 may include the same circuit configuration.

Referring to FIG. 3, a subpixel SP may include a switching transistor T1, a driving transistor T2, a capacitor Cst, a compensation circuit CC, and a light emitting device 190.

The switching transistor T1 is electrically connected to the data line DL and electrically connected to a first node N1. A gate electrode of the switching transistor T1 is electrically connected to the scan line SL. The switching transistor T1 transmits a data signal supplied through the data line DL to the first node N1 in response to a scan signal supplied through the scan line SL.

The capacitor Cst is electrically connected to the first node N1, and stores voltage applied to the first node N1.

The driving transistor T2 receives a high potential driving voltage EVDD, and is electrically connected to a first electrode (e.g., an anode) of the light emitting device 190. The driving transistor T2 may control the amount of driving current flowing in the light emitting device 190 in response to voltage applied to the gate electrode.

A semiconductor layer of each of the switching transistor T1 and the driving transistor T2 may include an oxide semiconductor material, such as indium-gallium-zinc-oxide (IGZO).

The light emitting device 190 outputs light corresponding to the driving current. The light emitting device 190 may output light corresponding to any one of red, green, blue, and white.

The light emitting device 190 may include a first electrode, an intermediate layer disposed on the first electrode, and a second electrode to which a common voltage is supplied. The intermediate layer may include one or more functional layers in addition to one or more emissive layers. The intermediate layer may include the same tandem stacking configuration on a subpixel-by-subpixel basis so as to emit white light or may include a patterned red emissive layer, green emissive layer, and blue emissive layer on a subpixel-by-subpixel basis so as to emit lights of different colors on a subpixel-by-subpixel basis. Where the intermediate layer of the light emitting device 190 emits white, the display device may further includes a color filter on an output side so as to transmit light of a selective wavelength in order to emit a predetermined color on a subpixel-by-subpixel basis.

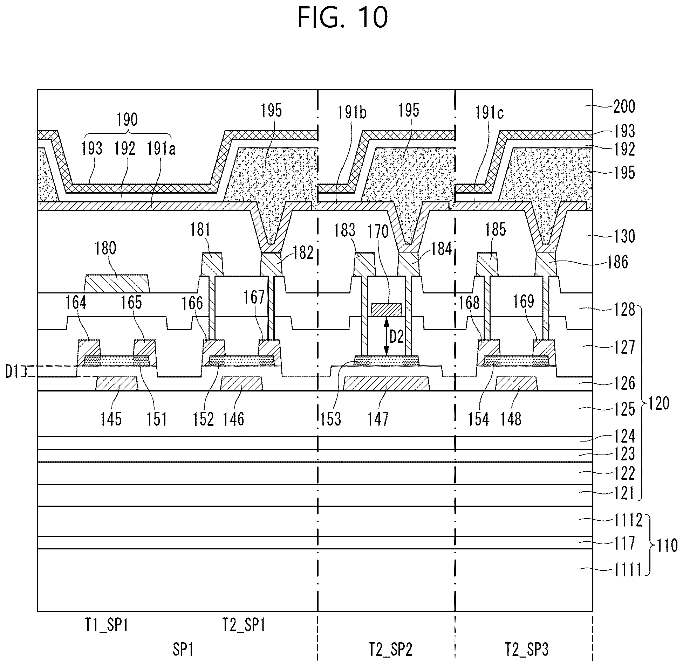

The first electrode may function as an anode, and the second electrode may function as a cathode. The light emitting device 190 may be a top emission diode or a bottom emission diode. The light emitting device 190 is substantially the same as a light emitting device 190 (see FIG. 10) having a sectional configuration to be described later.

The compensation circuit CC may be provided at the each of the subpixels SP1, SP2, and SP3 in order to compensate for a threshold voltage of the driving transistor T2. The compensation circuit CC may include one or more transistors. The compensation circuit CC may include one or more transistors and capacitors, and may be variously configured depending on a compensation method. The subpixel including the compensation circuit CC may include various structures, such as 3T1C, 4T2C, 5T2C, 6T1C, 6T2C, 7T1C, and 7T2C. For example, one or more transistors may be electrically connected between the driving transistor T2 and the light emitting device 190.

In the embodiment of FIG. 3, the light emitting device 190 may be an organic light emitting diode, but the present disclosure is not limited thereto, and various types of light emitting devices may be applied.

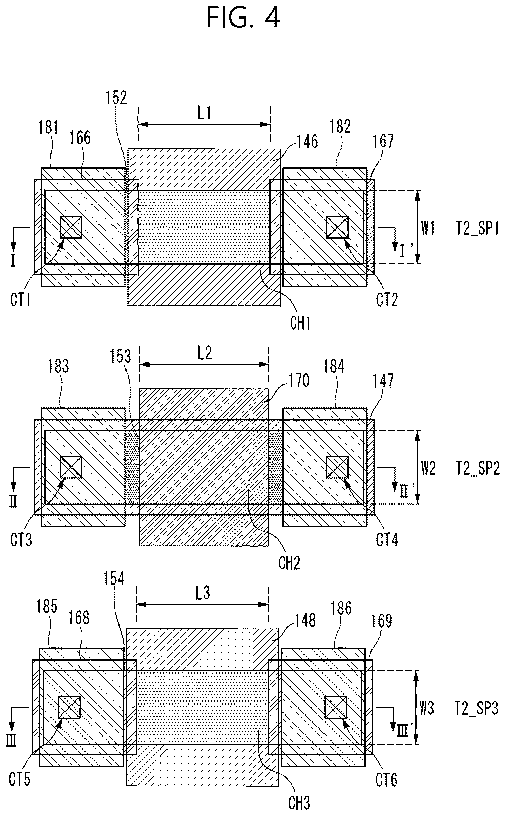

FIG. 4 is a plan view of the driving transistors of the first to third subpixels of FIG. 2, and FIG. 5 is a circuit diagram taken along line I-I', line II-II', and line III-III' of FIG. 4.

As shown in FIGs. 4 and 5, the display device according to the embodiment of the present disclosure includes first to third subpixels SP1, SP2, and SP3 and first to third driving transistors T2_SP1, T2_SP2, and T2_SP3 disposed on the substrate 110.

The second subpixel SP2 may emit light of a medium wavelength, the first subpixel SP1 may emit light of a short wavelength, and the third subpixel SP3 may emit light of a long wavelength. For example, the second subpixel SP2 may emit green light, the first subpixel SP1 may emit blue light, and the third subpixel SP3 may emit red light.

When the display device 1000 finally displays an image, the light of the medium wavelength, i.e., the light of the green wavelength, may have the largest proportion in the luminance. Therefore, the proportion of the gradation expression must be at least greater at the second subpixel SP2, which emits green light, than at the first and third subpixels SP1 and SP3.

Furthermore, since blue light has lower visibility than green light and red light and since the efficiency of the light emitting device emitting blue light is lower than that of the light emitting device emitting green light, the first driving transistor T2_SP1 of the first subpixel SP1 is required to have a structure having a large on-current value.

In the display device according to the embodiment of the present disclosure, the value of the S-factor (sub-threshold swing) of the second driving transistor T2_SP2 supplying the driving current at the second subpixel SP2 is greater than the value of the S-factor of each of the first and third driving transistors T2_SP1 and T2_SP3 of the first and third subpixels SP1 and SP3 to enrich the gradation expression of the second driving transistor T2_SP2.

Here, the S-factor (sub-threshold swing) may be obtained as the reciprocal of the slope of the transition section from the off-state to the on-state in the electrical characteristic curve of the driving transistor that generates the driving current and supplies the same to the light emitting device 190.

The S-factor may be evaluated as an indicator of the degree of variation of drain-source current Ids with respect to gate-source voltage Vgs, for example, in the transition section of the driving transistor. Here, the gate-source voltage Vgs may be a voltage difference between a gate electrode and a source electrode of the driving transistor, and the drain-source current Ids may be a driving current supplied to the light emitting device 190.

A larger S-factor means that the slope of the transition section becomes smaller, which means that the variation of the drain-source current Ids with respect to the gate voltage is smoothed out, whereby the gradation expression appears over a wider range of gate voltage variations. The increase in the S-factor in the second driving transistor T2_SP2 of the second subpixel SP2 means that a multi-level gradation expression is possible, the gradation expression may be stably and finely controlled, and a rich gradation expression is possible.

The display device according to the embodiment of the present disclosure has a structure in which, among the first to third driving transistors T2_SP1, T2_SP2, and T2_SP3 provided at the first subpixel SP1, the second subpixel SP2, and the third subpixel SP3 on the substrate 110, the first driving transistor T1 has a larger on-current value than the second driving transistor T2 and the second driving transistor T2 enables richer gradation expression than the first and third driving transistors T1 and T3. In the display device according to the embodiment of the present disclosure, the dimensions of active layers included in the first to third driving transistors T2 SP1, T2_SP2, and T2_SP3 are unified for the difference in characteristics between the first to third driving transistors T2_SP1, T2_SP2, and T2_SP3 of the first to third subpixels SP1, SP2, and SP3, but the active layers have different layered structures. The dimensions of the active layer may specifically refer to a channel area CH1, CH2, and CH3 defined in the active layer, and may include both a width and a length of the channel area CH1, CH2, and CH3.

Referring to FIG. 4, each of the widths W1, W2, and W3 of the channel areas CH1, CH2, and CH3 of the first to third driving transistors T2_SP1, T2_SP2, and T2_SP3 means the width of each active layer 152, 153 and 154, and each of the lengths L1, L2, and L3 of the channel areas CH1, CH2, and CH3 means the distance between the source-drain areas connected to the source-drain electrodes on both sides of each active layer 152, 153 and 154. In the first to third driving transistors T2_SP1, T2_SP2, and T2_SP3, each channel area may be determined as the area overlapping each of gate electrodes 146, 170, and 148, or may be defined as the area between cover electrodes 166/167 and 168/169 respectively abutting the active layers 152 and 154(in the first and third driving transistors T2_SP1 and T2_SP3).

In the display device according to the embodiment of the present disclosure, the widths W1, W2, and W3 of the channel areas CH1, CH2, and CH3 of the first to third driving transistors T2_SP1, T2_SP2, and T2_SP3 may be equal to each other.

In the display device according to the embodiment of the present disclosure, the lengths L1, L2, and L3 of the channel areas CH1, CH2, and CH3 of the first to third driving transistors T2_SP1, T2_SP2, and T2_SP3 may be equal to each other.

Furthermore, in the display device according to the embodiment of the present disclosure, the dimensions of the active layers included in the first to third driving transistors T2_SP1, T2_SP2, and T2_SP3 may be unified, whereby the layout configuration may be simplified compared to the structure that causes the first to third driving transistors to have different characteristics by adjusting W (channel width)/L (channel length) of the active layer, and therefore the design of subpixel-specific transistors may be simplified and mass productivity may be improved.

In the display device according to the embodiment of the present disclosure, the characteristic difference among the first to third driving transistors emitting lights of different colors may be obtained by a difference in the sectional configuration.

Specifically, the specific structure of each of the first to third driving transistors T2_SP1, T2_SP2, and T2_SP3 disposed respectively at the first to third subpixels SP1, SP2, and SP3 will be described with reference to FIGs. 4 and 5.

The substrate 110 may be made of a plastic material having flexible properties. In an example, the substrate 110 may include first and second organic layers 1111 and 1112 overlapping each other with an inorganic interlayer insulating layer 117 therebetween. The first and second organic layers 1111 and 1112 may include different organic layers that are homogeneous or heterogeneous, such as, polyethylene terephthalate (PET) and polyimide. In some cases, an adhesive layer such as a pressure sensitive adhesive (PSA) may be provided between the first and second organic layers 1111 and 1112.

A plurality of stacked insulating layers 120 (121, 122, 123, 124, 125, and 126, 127, and 128) are disposed on the active area AA and the non-active area NA of the substrate 110 to insulate the electrodes and the active layers 152, 153, and 154 on different layers constituting the driving transistors T2_SP1, T2_SP2, and T2_SP3 from each other. The insulating layers 120 may include a first insulating layer 121, a second insulating layer 122, a third insulating layer 123, a fourth insulating layer 124, a fifth insulating layer 125, a sixth insulating layer 126, a seventh insulating layer 127, and an eighth insulating layer 128.

The first driving transistor T2_SP1 disposed at the first subpixel SP1 on the substrate 110 includes a first active layer 152, a first gate electrode 146 disposed under the first active layer 152 with the sixth insulating layer 126 interposed therebetween, and first and second cover electrodes 166 and 167 covering the upper and side portions of both (opposing) edges of the first active layer 152, respectively.

The second driving transistor T2_SP2 disposed at the second subpixel SP2 on the substrate 110 includes a second active layer 153 and a second gate electrode 170 disposed above the second active layer 153 with the seventh insulating layer 127 therebetween.

The third driving transistor T2_SP3 disposed at the third subpixel SP3 on the substrate 110, which has the same stacking configuration as the first driving transistor T2_SP1, includes a first active layer 154, a first gate electrode 148 disposed under the first active layer 154 with the sixth insulating layer 126 interposed therebetween, and first and second cover electrodes 168 and 169 covering the upper and side portions of both edges of the first active layer 154.

The first cover electrodes 166 and 168 and second cover electrodes 167 and 169 may define channel areas CH1 and CH3 in the first active layers 152 and 154 at an exposure region, respectively, and may be disposed so as to cover upper and side surfaces of the first active layers 152 and 154, respectively to block light directed from the light emitting device 190 toward the substrate 110 or light incident through the substrate 110 from traveling toward and entering the first active layers 152 and 154 while being totally reflected through the insulating layer 120, thus protecting the first active layers 152 and 154.

The sixth insulating layer 126 is located under the first active layers 152 and 154 and the second active layer 153 and may also be referred to as a lower insulating layer. The seventh insulating layer 127 is located above the first active layers 152 and 154 and the second active layer 153 and may also be referred to as an upper insulating layer.

Here, the first active layers 152 and 154 and the second active layer 153 are stacked at the same layer and may each include, for example, an oxide semiconductor.

Each of the first active layers 152 and 154 and the second active layer 153 may include at least one of IZO (InZnO)-based, IGO (InGaO)-based, ITO (InSnO)-based, IGZO (InGaZnO)-based, IGZTO (InGaZnSnO)-based, GZTO (GaZnSnO)-based, GZO (GaZnO)-based, ITZO (InSnZnO)-based, and FIZO (FeInZnO)-based oxide semiconductor materials.

The first active layers 152 and 154 and the second active layer 153 may be disposed at the same layer and be formed in the same dimensions, which simplifies the layout and prevents or suppresses area-specific defects, thereby enhancing performance.

The sixth insulating layer 126 disposed under the active layers 152, 153, and 154 of the first to third driving transistors T2_SP1, T2_SP2, and T2_SP3 has a relatively small first thickness D1 in the configuration of the insulating layer 120, and the seventh insulating layer 127 disposed above the active layers 152, 153, and 154 has a relatively large second thickness D2 in the configuration of the insulating layer 120.

The first driving transistor T2_SP1 and the third driving transistor T2_SP3 have the sixth insulating layer 126, which has a relatively small thickness, between the first active layers 152 and 154 and the first gate electrodes 146 and 148, and the sixth insulating layer 126 is used as a gate insulating layer. In the first driving transistor T2_SP1 and the third driving transistor T2_SP3, the vertical distance between the first active layers 152 and 154 and the first gate electrodes 146 and 148 is shortened, which has the effect of increasing on current Ion when gate voltage is applied to the first gate electrodes 146 and 148 without increasing the channel width of the first active layers 152 and 154.

The second driving transistor T2_SP2 has the seventh insulating layer 127 between the second active layer 153 and the second gate electrode 170, and the seventh insulating layer 127 is used as a gate insulating layer. The second driving transistor T2_SP2 has the effect of increasing the S-factor by increasing the thickness of the gate insulating layer such that the value of the driving current changes gradually with respect to gate voltage when the gate voltage is applied. Accordingly, the second driving transistor T2_SP2 enriches the gradation expression, and the gradation expression may be enriched in the display device by increasing the S-factor of the second driving transistor T2_SP2 disposed at the second subpixel SP, which has a relatively large influence on the luminance expression.

The first gate electrodes 146 and 148 of the first driving transistor T2_SP1 and the third driving transistor T2_SP3 may supply the gate voltage, and may be located under the first active layers 152 and 154 to shield or block light incident from or entering through the substrate 110.

The first gate electrodes 146 and 148 of the first driving transistor T2_SP1 and the third driving transistor T2_SP3 are located under the first active layers 152 and 154, and the first gate electrodes 146 and 148 may not directly define or correspond to conductorized areas (e.g., source and drain areas)of the first active layers 152 and 154.

Therefore, the first driving transistor T2_SP1 and the third driving transistor T2_SP3 are provided with first and second cover electrodes 166, 167, 168, and 169 covering the upper and side portions of both (opposing) edges of the first active layers 152 and 154, respectively. The conductive properties of the cover electrodes 166, 167, 168, and 169 lower the resistivity of contacted areas of the first active layers 152 and 154, and the contacted areas are defined as source-drain areas SDA and SDC. The areas of the first active layers 152 and 154 that are not connected to the cover electrodes 166, 167, 168, and 169 are intrinsic areas, which may function as channel areas CH1 and CH3.

In the second driving transistor T2_SP2, the doped area, formed by doping the second active layer 153 with the second gate electrode 170 serving as a mask, may be defined as a conductorized source-drain area SDB, or a low-resistance source-drain area SDB may be defined by applying a conductorization process by plasma treatment. Here, the area overlapping the second gate electrode 170 may be an intrinsic area that is undoped and not conductorized, which may function as a channel area CH2.

The channel areas CH1, CH2, and CH3 of the driving transistors T2_SP1, T2_SP2, and T2_SP3 of the subpixels may have the same dimensions by equating the first width W1 and first length L1 of the channel area CH1 defined as the area of the first active layer 152 located between the first and second cover electrodes 166 and 167 of the first driving transistor T2_SP1 with the second width W2 and second length L2 of the channel area CH2 of the second active layer 153 defined as the overlap area of the second gate electrode 170 of the second driving transistor T2_SP2. The third width W3 and the third length L3 of the channel area CH3 in the first active layer 154 of the third driving transistor T2_SP3, which has the same stacking structure as the first driving transistor T2_SP1, may be equal to the first width W1 and the first length L1 of the channel area CH1 in the first active layer 152 of the first driving transistor T2_SP1.

The first driving transistor T2_SP1 disposed at the first subpixel SP1 may include a first source-drain electrode 181 connected to the first cover electrode 166 and a second source-drain electrode 182 connected to the second cover electrode 167. The third driving transistor T2_SP3 disposed at the third subpixel SP3 may include a first source-drain electrode 185 connected to the first cover electrode 168 and a second source-drain electrode 186 connected to the second cover electrode 169.

In the first driving transistor T2_SP1, the first source-drain electrode 181 and the second source-drain electrode 182 may be connected to the first and second cover electrodes 166 and 167, respectively, via first and second contact holes CT1 and CT2 provided in the seventh and eighth insulating layers 127 and 128.

In the third driving transistor T2_SP3, the first source-drain electrode 185 and the second source-drain electrode 186 may be connected to the first and second cover electrodes 168 and 169, respectively, via fifth and sixth contact holes CT5 and CT6 provided in the seventh and eighth insulating layers 127 and 128.

The second driving transistor T2_SP2 disposed at the second subpixel SP2 may include a third source-drain electrode 183 and a fourth source-drain electrode 184 connected respectively to both (opposing) sides of the second active layer 153.

In the second driving transistor T2_SP2, the third source-drain electrode 183 and the fourth source-drain electrode 184 may be connected to upper parts of both sides of the second active layer 153 via third and fourth contact holes CT3 and CT4 provided in the seventh and eighth insulating layers 127 and 128.

The first to fourth source-drain electrodes 181/185, 182/186, 183, and 184 may be disposed at the same layer. The transistors having different stack structures T2_SP1/T2_SP3 and T2_SP2 may include source-drain electrodes of the same material at the same layer. Therefore it is possible to reduce the material usage and to reduce the number of process masks when forming the same.

The second driving transistor T2_SP2 may further include a shielding pattern 147 under the second active layer 153 to prevent or block light incident from or entering through the substrate 110 from affecting the second active layer 153 of the second driving transistor T2_SP2.

The shielding pattern 147 may be disposed at the same layer as the first gate electrodes 146 and 148 of the first driving transistor T2_SP1 and the third driving transistor T2_SP3 to reduce the number of masks and reduce the material usage of the conductive layer.

The sixth insulating layer 126 may include an inorganic insulating layer made of a silicon oxide. Where in direct contact with the first active layers 152 and 154 and the second active layer 153 including an oxide semiconductor, the effects of residual hydrogen in the insulating layer may be prevented or suppressed.

The seventh insulating layer 127 may be thicker than the sixth insulating layer 126, and may include a plurality of insulating layers. Among the plurality of insulating layers of the seventh insulating layer 127, the insulating layer abutting the first active layers 152 and 154 and the second active layer 153 may include an inorganic insulating layer made of a silicon oxide, and may prevent the first active layers 152 and 154 and the second active layer 153 from being affected by residual hydrogen in the insulating layer.

Each of the first to third driving transistors T2_SP1, T2_SP2, and T2_SP3 may be connected to the light emitting device 190.

A planarization layer 130 covering the first to third driving transistors T2_SP1, T2_SP2, and T2_SP3 is disposed on the first to third driving transistors T2_SP1, T2_SP2, and T2_SP3.

The light emitting device 190 includes a first electrode 191 (191a, 191b, or 191c), an intermediate layer 191, and a second electrode 193. The first electrode 191 (191a, 191b, or 191c) may be disposed in a corresponding one of the first to third subpixels SP1, SP2, and SP3, and the area of the first electrode 191 (191a, 191b, or 191c) may be exposed by a pixel defining layer 195 that defines the emissive area of each subpixel.

The source-drain electrodes 182, 184, and 186 of the first to third driving transistors T2_SP1, T2_SP2, and T2_SP3 may be connected to the first electrode 191 (191a, 191b, or 191c) of the light emitting device 190, and driving current for each subpixel may be applied independently.

The first to fifth insulating layers 121, 122, 123, 124, and 125 disposed between the substrate 110, and the first gate electrodes 146 and 148 and the shielding pattern 147, may function as buffer layers for the first to third driving transistors T2_SP1, T2_SP2, and T2_SP3, which include oxide semiconductors as active layers. These insulating layers may planarize formation surfaces of the first to third driving transistors T2_SP1, T2_SP2, and T2_SP3 and prevent impurities from the lower configuration from affecting the first to third driving transistors T2_SP1, T2_SP2, and T2_SP3.

The planarization layer 130 covering the first to third driving transistors T2_SP1, T2_SP2, and T2_SP3 may include an organic material. The organic material may include at least one of an acrylic resin, a phenolic resin, a polyimide resin, an unsaturated polyester resin, a polyamide resin, or a polyester resin, benzocyclobutene, a polyphenylene resin, and a polyphenylene sulfide resin.

The first electrode 191 (191a, 191b, or 191c) at the first to third subpixels SP1, SP2, and SP3 may be further provided on the planarization layer 130, and may be connected to a corresponding one of the source-drain electrodes 182, 184, and 186 of the driving transistors T2_SP1, T2_SP2, and T2_SP3 via contact holes PCT in the planarization layer 130. The first electrode 191 (191a, 191b, or 191c), the second electrode 193 opposite thereto, and the intermediate layer 192 between the first electrode 191 (191a, 191b, or 191c) and the second electrode 193 constitute the light emitting device 190.

One of the first electrode 191 (191a, 191b, or 191c) and the second electrode 193 may include a reflective electrode, and the other may include a transparent electrode or a transflective electrode.

Where the first electrode 191 (191a, 191b, or 191c) includes a reflective electrode, the first electrode 191 (191a, 191b, or 191c) may function to shield or block light from being incident on the transistors T1 and T2 thereunder. The first electrode 191 (191a, 191b, or 191c) may include, for example, a stacked structure of a first transparent electrode, a reflective electrode, and a second transparent electrode. The second transparent electrode, which is the uppermost electrode of the first electrode 191 (191a, 191b, or 191c), may be a dielectric and may lower the barrier through which holes are injected at the interface with the intermediate layer 192. Here, the first and second transparent electrodes may be transparent oxide electrodes such as ITO or IZO. The reflective electrode may include silver, a silver alloy such as APC (Ag-Pd-Cu), aluminum, or an aluminum alloy.

For example, the first electrode 191 (191a, 191b, or 191c) may be formed as a multilayer structure, such as a stack structure of aluminum (Al) and titanium (Ti) (Ti/Al/Ti), a stack structure of aluminum (Al) and ITO (ITO/Al/ITO), an APC (Ag/Pd/Cu) alloy, and a stack structure of an APC alloy and ITO (ITO/APC/ITO), or a stack structure of silver (Ag) and a molybdenum/titanium alloy (Ag/MoTi), or may include a monolayer structure made of any one selected from along silver (Ag), aluminum (Al), molybdenum (Mo), gold (Au), magnesium (Mg), calcium (Ca), and barium (Ba), or an alloy of two or more thereof.

The pixel defining layer 195 may be disposed so as to surround the edge of the first electrode 191 (191a, 191b, or 191c), and an emissive area may be defined in an open area of the pixel defining layer 195. The pixel defining layer 195 may extend into the non-active area NA, and may be at least partially overlap the gate-in-panel GIP (FIG. 1).

The pixel defining layer 195 may include an inorganic material or an organic material. The pixel defining layer 195 may include an opaque material (e.g., black material) to prevent or suppress optical interference between neighboring subpixels SP. In this case, the pixel defining layer 195 may include a shielding material including at least one of color pigment, organic black, and carbon.

The intermediate layer 192 may include a hole injection layer, a hole transport layer, an emissive layer, an electron transport layer, and an electron injection layer. The intermediate layer 192 may be formed in a tandem structure including a plurality of stacks, each including a hole transport layer, an emissive layer, and an electron transport layer, and a charge generation layer provided between the adjacent stacks. The charge generation layer may include, for example, an n-type charge generation layer and a p-type charge generation layer.

The emissive layer(s) included in the intermediate layer 192 may be configured differently for each subpixel. The emissive layer(s) may include a red emissive layer that emits red light, a green emissive layer that emits green light, and a blue emissive layer that emits blue light. The red emissive layer, the green emissive layer, and the blue emissive layer may be disposed per subpixel SP on the first electrode 191 (191a, 191b, or 191c).

For example, a red emissive layer may be patterned and disposed at a red subpixel, a green emissive layer may be patterned and disposed at a green subpixel, and a blue emissive layer may be patterned and disposed at a blue subpixel. However, the present disclosure is not necessarily limited thereto, and at least two of the red emissive layer, the green emissive layer, and the blue emissive layer may be stacked and disposed at one subpixel SP.

In some cases, the emissive layer may be a white emissive layer that emits white light. In this case, the emissive layer EL may be in the form of a common layer in which one or more layers are disposed in common at the subpixels SP rather than in the form of a pattern at the subpixels SP.

As described above, the intermediate layer 192 may be disposed in a tandem structure of two or more stacks. In this case, each of the light emitting devices 190 may include a charge generation layer disposed between the adjacent stacks. The charge generation layer may be a common layer disposed on the entire surface of the active area AA.

The second electrode 193 may be formed by thinning a transparent electrode, such as ITO or IZO, or a transflective electrode, such as silver, a silver alloy, magnesium, a magnesium alloy, ytterbium (Yb), or an ytterbium alloy. In other embodiments, the second electrode 193 may be partially removed from a transmission area or formed with a thin thickness to increase the transmittance in the transmission area. The second electrode 193 may be a common layer disposed in common at the subpixels SP and applying the same voltage. To this end, the second electrode 193 may extend from the active area AA to a part of the non-active area NA.

The second electrode 193 may be a light transmissive electrode. The second electrode 193 may include a transparent conductive material (TCO), such as ITO or IZO, or a semi-transmissive conductive material such as magnesium (Mg), silver (Ag), or an alloy of magnesium (Mg) and silver (Ag) that is capable of transmitting light. If the second electrode 193 includes a semi-transmissive conductive material, light emission efficiency may be increased by the microcavity effect.

The top emission type light emitting device 190 was previously described by way of example. However, the light emitting device 190 of the present disclosure is not limited thereto, and may be a bottom emission type light emitting device in which light emitted from the intermediate layer 192 is emitted downward toward the substrate 110. In this case, the first electrode 191 (191a, 191b, or 191c) may be made of a transparent conductive material or a semi-transparent conductive material, and the second electrode 193 may be made of a reflective conductive material.

A capping layer (not shown) may be further formed on the second electrode 193 to protect the second electrode 193 of the light emitting device 190 and to increase upward light emitting efficiency.

On each of the subpixels SP1, SP2, and SP3, an encapsulation layer 200 is disposed on the light emitting device 190 so as to cover the light emitting device 190. The encapsulation layer 200 may cover the active area AA and the non-active area NA to prevent oxygen or moisture from infiltrating the light emitting device 190. Other layers, such as a capping layer, may be interposed between the encapsulation layer 200 and the second electrode 193 as desired.

The encapsulation layer 200 may include a plurality of layers. The encapsulation layer 200 may have a structure in which an inorganic layer including an inorganic insulating material and an organic layer including an organic insulating material are alternately stacked. For example, the inorganic insulating material may include one or more materials such as silicon oxide, silicon nitride, and/or silicon oxynitride.

The organic insulating material may include one or more materials selected from the group consisting of polyethylene terephthalate, polyethylene naphthalate, polycarbonate, polyimide, polyethylene sulfonate, polyoxymethylene, polyarylate, and hexamethyldisiloxane.

Depending on the type of a pixel circuit provided at the subpixels, the driving transistor T2 may be directly connected to the light emitting device, or one or more transistors or capacitors may be further provided between the light emitting device 190 and the driving transistor.

In the display device according to an example embodiment of the present disclosure, the first to third driving transistors T2_SP1, T2_SP2, and T2_SP3 of the first, second, and third subpixels SP1, SP2, and SP3 may have the same dimensions but different stacking structures to optimize the performance of the driving transistors T2 of subpixels having different emission colors for the purpose of on-current optimization/improvement and gradation expression diversification.

Furthermore, the driving transistors of the different subpixels according to an example embodiment of the present disclosure may achieve improved performance by changing the stacking structure without changing the W/L of the active layer, depending on the performance specifications of the transistors. Furthermore, the active layers of the driving transistors of different subpixels may have the same dimensions, which simplifies the layout, thereby improving the yield and better facilitating mass production application. In the display device according to an example embodiment of the present disclosure, the driving transistors of the first to third subpixels emitting different colors may have the same W/L.

The driving transistor of the first subpixel SP1 emitting blue color provides a relatively large on-current for driving the light emitting device 190 in consideration of the low efficiency of the light emitting device 190 emitting blue color. Therefore the sixth insulating layer 126 having a relatively small first thickness D1 may be provided between the first gate electrode 146 and the first active layer 152 and the first gate electrode 146 having a stack structure of a molybdenum layer/titanium layer with high conductivity may be provided to improve the on-current.

The driving transistor of the second subpixel SP2 emitting green color has a relatively large proportion in the luminance expression of the entire display device. In particular, in the gradation expression, a gentle section in the transition section of the characteristic curve of the driving current Ids with respect to the gate voltage Vgs at low gradation may be implemented. Therefore the S-factor may be increased. The driving transistor of the second subpixel SP2 according to an example embodiment of the present disclosure may enrich the low-gradation expression of the driving transistor of the second subpixel by increasing the S-factor by applying a relatively large thickness D2 of the gate insulating layer (here, the seventh insulating layer 127) that is different from the driving transistors of the first and third subpixels SP1 and SP3, without changing the width and length of the channel area CH2 of the second active layer 153.

In contrast to a related art method of increasing the S-factor by increasing the length of the active layer (semiconductor layer) of the transistor for low-gradation expression of the transistor of the green-emitting subpixel, the transistor according to an example embodiment of the present disclosure may increase the S-factor by increasing the thickness of the gate insulating layer (O-GI) of the transistor including an oxide semiconductor to be greater than in the related art structure, instead of adjusting W/L of the channel of the active layer.

Hereinafter, example configurations of the switching transistor and the driving transistor for each subpixel will be described.

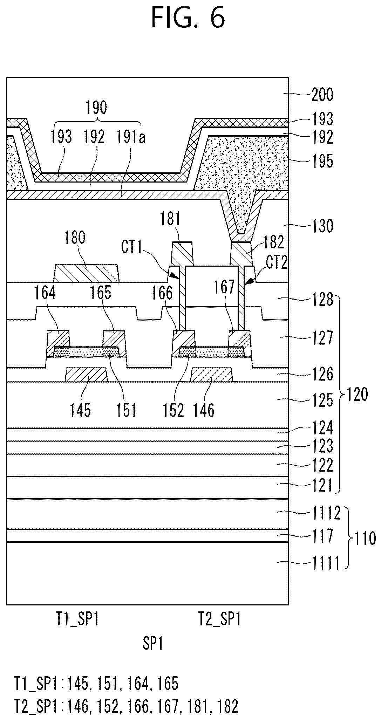

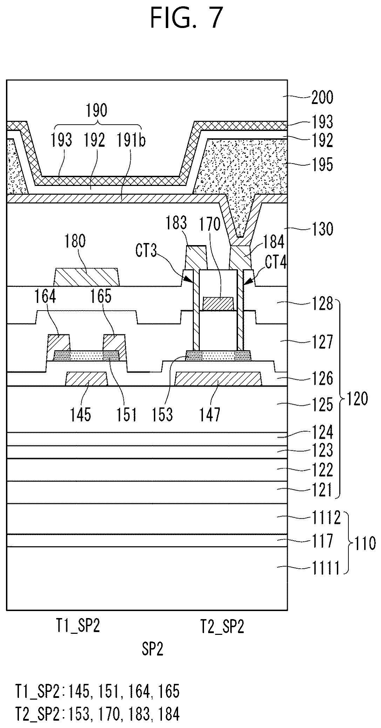

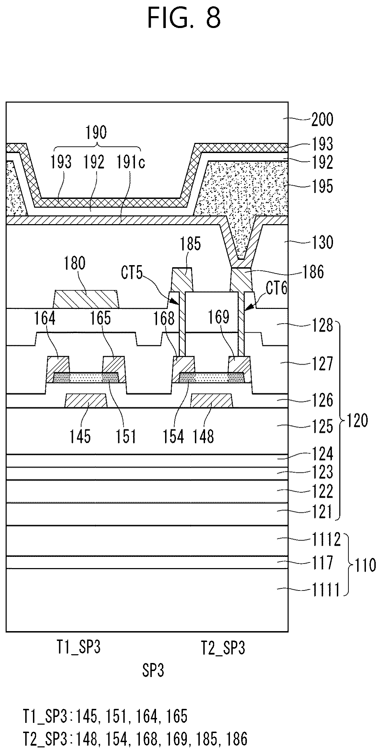

FIG. 6 is an embodiment of a sectional view of the first subpixel. FIG. 7 is an embodiment of a sectional view of the second subpixel. FIG. 8 is an embodiment of a sectional view of the third subpixel.

As shown in FIGs. 6 to 8, the first to third subpixels SP1, SP2, and SP3 emitting different colors may include switching transistors T1_SP1, T1_SP2, and T1_SP3, respectively, that have the same stack structure.

Each of the switching transistors T1_SP1, T1_SP2, and T1_SP3 of the subpixels may include an active layer (or switching transistor active layer)151 provided at the same layer as the active layers 152, 153, and 154 of the first to third driving transistors T2_SP1, T2_SP2, and T2_SP3, a gate electrode 145 (or switching transistor gate electrode) disposed under the active layer 151 with the sixth insulating layer 126 interposed therebetween, and source-drain electrodes 164 and 165 covering the upper and side portions of both (opposing) edges of the active layer 151.

The source-drain electrodes 164 and 165 of each of the first to third switching transistor T1_SP1, T1_SP2, and T1_SP3 may have an identical or similar shape to the first and second cover electrodes 166/168 and 167/169 of the first and third driving transistors T2_SP1 and T2_SP3 respectively.

In the switching transistor T1(T1_SP1, T1_SP2, and T1_SP3), the area of the active layer 151 exposed from the source-drain electrodes 164 and 165 may be defined as a channel area. The source-drain electrodes 164 and 165 of the switching transistor T1 may be disposed covering the upper surface and side portions of the active layer 151 to block light directed from the light emitting device 190 toward the substrate 110 or to block light incident through the substrate 110 from traveling toward and entering the active layer 151 while being totally reflected through the insulating layer 120, thereby preventing the characteristics of the switching transistor from being altered by internal light.

At least the channel area of the active layer 151 of the switching transistor may be protected by a gate electrode 145 disposed under the active layer 151. The gate electrode 145 prevents the active layer 151 from being affected by light incident from the substrate 110.

A protective electrode 180 overlapping the active layers 151 of the switching transistors T1_SP1, T1_SP2, and T1_SP3 may be further provided on the switching transistors T1_SP1, T1_SP2, and T1_SP3. The protective electrode 180 may be isolated or insulated from the switching transistors T1_SP1, T1_SP2, and T1_SP3 by the seventh insulating layer 127 and the eighth insulating layer 128 disposed between the protective electrode 180 and the source-drain electrodes 164 and 165. The protective electrode 180 may block light from the light emitting device 190 from being incident on the switching transistors T1_SP1, T1_SP2, and T1_SP3 and prevent the electrical operation of the light emitting device 190 from causing interference with the operation of the switching transistors T1_SP1, T1_SP2, and T1_SP3.

The gate electrode 145 of the switching transistor T1_SP1, T1_SP2, and T1_SP3 may be disposed at the same layer as the first gate electrodes 146 of the first and third driving transistors T2_SP1 and T2_SP3, and the shielding pattern 147 of the second driving transistor T2_SP2. Furthermore, the gate electrode 145 of the switching transistor T1_SP1, T1_SP2, and T1_SP3, the first gate electrodes 146 of the first and third driving transistors T2_SP1 and T2_SP3, and the shielding pattern 147 of the second driving transistor T2_SP2 may have excellent conductivity in functioning as gate electrodes, and may include for example, a stack of the molybdenum layer/titanium layer. Furthermore, the shielding pattern 147 and the gate electrodes 145, 146, which are disposed respectively at a relatively short vertical distance D1 from the active layers 153, 151, 152, and 154 of the oxide semiconductor layer, may have the function of capturing hydrogen.

The gate electrode 145 of the switching transistor (T1_SP1, T1_SP2, or T1_SP3) overlaps the channel area of the active layer 151. The source-drain electrodes 164 and 165 overlap the active layer 151 without any horizontal separation from the gate electrode 145 and may be directly connected to the active layer 151.

In the switching transistor (T1_SP1, T1_SP2, or T1_SP3), the source-drain electrodes 164 and 165 may be provided on the upper surface and the side surface of the active layer 151 including an oxide semiconductor material in the shape of a cover. In addition, the gate electrode 145 may be provided under the active layer 151 and the protective electrode 180 may be provided on the active layer 151 such that the upper part, the side surface, and the lower part of the active layer 151 are all protected by metal, whereby the active layer 151 may be shielded against both internal light on the substrate 110 or external light from below the substrate 110. Thus, the active layer 151 of the light-sensitive switching transistor (T1_SP1, T1_SP2, or T1_SP3) may be protected by the metal constituting the upper part, the side surface, and the lower part thereof, and the potentially adverse effect of the internal and external light may be effectively prevented or suppressed. Thus, the reliability to light may be improved, both the on and off characteristics may be stabilized, and the phenomenon of the threshold voltage being negatively shifted may be prevented or suppressed.

Furthermore, the reliability of the switching transistor operating at high speed may be improved, resulting in an improved lifespan. Therefore the lifespan of the display device may also be improved.

The switching transistor (T1_SP1, T1_SP2, or T1_SP3) may implement high-speed on/off switching, and for rapid switching, a relatively thin sixth insulating layer 126 is used as a gate insulating layer, and the gate electrode 145 having the stack structure of the molybdenum layer/titanium layer may be used to reduce the parasitic capacity of the gate insulating layer and increase the conductivity of the gate electrode 145(e.g., the source-drain electrodes 164 and 165 are not spaced apart from the gate electrode 145 in a plan view), which is advantageous for high-speed operation.

With respect to the driving transistors T2, the example configurations of the driving transistors T2_SP1, T2_SP2, and T2_SP3 shown in FIGs. 6 to 8 have been described above with reference to FIGs. 4 and 5, and therefore a description of the same configurations will be omitted.

Hereinafter, example configurations of the third transistor T3 including another semiconductor material as an active layer and the storage capacitor Cst will be described, in addition to the transistors T1 and T2 each including an oxide semiconductor material as an active layer.

The third transistor T3 may be additionally provided at the subpixels in a different form from the switching transistors T1_SP1, T1_SP2, and T1_SP3 provided at the subpixels described with reference to FIGs. 6 to 8, or may be included as a type of the driving transistor at the gate-in-panel GIP disposed at the non-active area NA described with reference to FIG. 1.

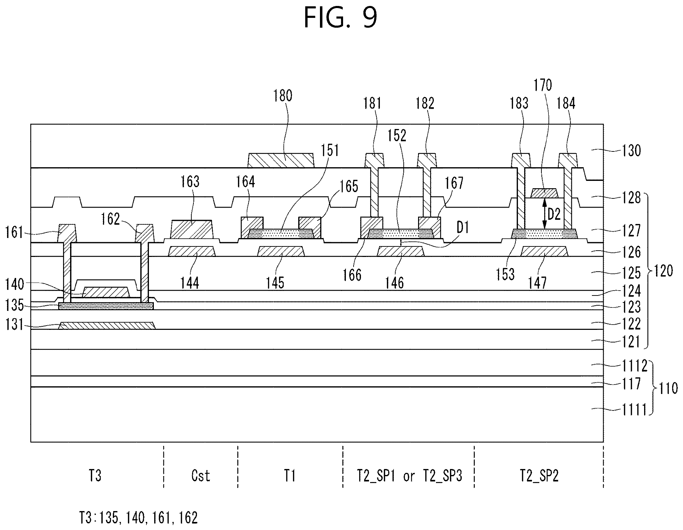

FIG. 9 is a sectional view showing transistors having different stack structures and a storage capacitor in the display device according to the embodiment of the present disclosure.

As shown in FIG. 9, a third transistor T3 may be further disposed on the substrate 110 and may include a third gate electrode 140 disposed under a first gate electrode 146, a third active layer 135 disposed under the third gate electrode 140 with a fourth insulating layer 124 interposed therebetween, and fifth and sixth source-drain electrodes 161 and 162 connected respectively to both (opposing) sides of the third active layer 135 and disposed at the same layer as the first and second cover electrodes 166 and.

The third transistor T3 may be further provided as another switching transistor at the subpixel SP or may be further included as a driving transistor of the gate-in-panel GIP at the non-active area NA of the substrate 110.

Further, each of the subpixels SP1, SP2, and SP3 may further include a storage capacitor Cst connected to a corresponding one of the driving transistors T2_SP1, T2_SP2, and T2_SP3. The storage capacitor Cst may include a first storage electrode 144 disposed at the same layer as the first gate electrode 146 of the first driving transistor T2_SP1 and a second storage electrode 163 disposed at the same layer as the source-drain electrodes 164 and 165 of the switching transistor and the cover electrodes 166 and 167 of the first driving transistor T2_SP2. A sixth insulating layer 126 having a relatively small first thickness D1 may be disposed between the first and second storage electrodes 144 and 163 of the storage capacitor Cst to improve the capacity of the storage capacitor.

FIG. 10 is a sectional view showing the display device according to the embodiment of the present disclosure.

Hereinafter, a display device including a third transistor T3 as a driving transistor at a gate-in-panel GIP of a non-active area NA of a substrate 110 including a switching transistor T1, a driving transistor T2, and a storage capacitor Cst at a subpixel in the active area AA will be described with reference to FIGs. 9 and 10.

The substrate 110 may be made of a plastic material having flexible properties. In an example, the substrate 110 may include first and second organic layers 1111 and 1112 overlapping each other with an inorganic interlayer insulating layer 117 therebetween. The first and second organic layers 1111 and 1112 may include different organic layers that are homogeneous or heterogeneous, such as, polyethylene terephthalate (PET) and polyimide. In some cases, an adhesive layer such as a pressure sensitive adhesive (PSA) may be provided between the first and second organic layers 1111 and 1112.

In another example, the substrate 110 may include a thin, flexible glass material.

The substrate 110 serves to support and protect components of the display device 1000 disposed thereon.

An active area AA of the substrate 110 may include a switching transistor T1 (or a first transistor) connected to a scan line SL (FIG. 2) and a data line DL, and a driving transistor T2 (or a second transistor) electrically connected to a light emitting device 190. The switching transistor T1 and the driving transistor T2 may be connected to each other, and a part of a compensation circuit may be provided therebetween in some cases.

A plurality of stacked insulating layers 120 (121, 122, 123, 124, 125, and 126, 127, and 128) is disposed on the active area AA and the non-active area NA of the substrate 110 to insulate electrodes and active layers 151 and 152/153/154 respectively constituting the switching and driving transistors T1 and T2 from each other. The insulating layers 120 may include a first insulating layer 121, a second insulating layer 122, a third insulating layer 123, a fourth insulating layer 124, a fifth insulating layer 125, a sixth insulating layer 126, a seventh insulating layer 127, and an eighth insulating layer 128.

The first insulating layer 121 may be disposed at the active area AA and the non-active area NA on the substrate 110. The first insulating layer 121 may be referred to as a buffer layer and may function in the same manner as any buffer layer known in the art. The first insulating layer 121 may be disposed on the substrate 110 to protect structures located on substrate 110 from moisture penetrating through the substrate 110 and to planarize the surface of the substrate 110.

The first insulating layer 121 may extend to the edge of the substrate 110 to prevent or suppress moisture from penetrating from the edge of the substrate 110. The first insulating layer 121 may be a single inorganic layer or may include a plurality of alternately stacked inorganic layers.

For example, the first insulating layer 121 may include one or more of silicon oxide (SiOx), silicon nitride (SiNx), silicon oxynitride (SiOxNy), and a multilayer layer in which the above-described inorganic layers are stacked.

A shielding pattern 131 made of a conductive metal material may be provided on the first insulating layer 121. Specifically, the conductive metal material may include at least one of an aluminum-based metal, such as aluminum (Al) or an aluminum alloy, a silver-based metal, such as silver (Ag) or a silver alloy, a copper-based metal, such as copper (Cu) or a copper alloy, a molybdenum-based metal, such as molybdenum (Mo) or a molybdenum alloy, chromium (Cr), tantalum (Ta), neodymium (Nd), and titanium (Ti).

The second insulating layer 122 may be disposed on the first insulating layer 121 and the shielding pattern 131. The second insulating layer 122 may function as a buffer layer for the third transistor T3 and may planarize a formation surface of a third active layer 135.

The second insulating layer 122 may include an inorganic material. The inorganic material may include, for example, silicon nitride (SiNx).

Amorphous silicon may be deposited on the second insulating layer 122 and crystallized to form crystalline silicon, which may then be patterned to form a third active layer 135.

The third insulating layer 123 may be disposed on the second insulating layer 122 and the third active layer 135. The third insulating layer 123 may function as a gate insulating layer for the third transistor T3. The third insulating layer 123 may include an inorganic layer, such as a silicon oxide (SiOx) layer, a silicon nitride (SiNx) layer, or a multilayer layer thereof.

A third gate electrode 140 made of a conductive metal material may be disposed on the third insulating layer 123. Specifically, the conductive metal material may include at least one of an aluminum-based metal, such as aluminum (Al) or an aluminum alloy, a silver-based metal, such as silver (Ag) or a silver alloy, a copper-based metal, such as copper (Cu) or a copper alloy, a molybdenum-based metal, such as molybdenum (Mo) or a molybdenum alloy, chromium (Cr), tantalum (Ta), neodymium (Nd), and titanium (Ti).

The fourth insulating layer 124 and the fifth insulating layer 125 may be sequentially disposed on the third insulating layer 123 and the third gate electrode 140.

The fourth and fifth insulating layers 124 and 125 may be located under the gate electrode 145 of the switching transistor T1 and the gate electrodes 146, and 148 of the driving transistors T2_SP1 and T2_SP3 and the shielding pattern 147 of the driving transistors T2_SP2 and may function as buffer layers.

The fifth insulating layer 125 may serve to planarize the surface of the area where gate electrodes 145, 146, and 148 and the shielding pattern 147 disposed thereon are formed.

Each of the fourth and fifth insulating layers 124 and 125 may include an inorganic material. The inorganic material may include, for example, a silicon oxide (SiOx) layer or a multilayer layer in which inorganic layers are stacked.

The fourth and fifth insulating layers 124 and 125 may be used as interlayer insulating layers for the third transistor T3 including the third active layer 135.

A first storage electrode 144, a gate electrode 145 of the switching transistor T1, first gate electrodes 146 and 148 of the first and third driving transistors T2_SP1 and T2_SP3, and a shielding pattern 147 of the second driving transistor T2_SP2, each of which is made of a conductive material, are provided on the fifth insulating layer 125.

Each of the first storage electrode 144, the gate electrode 145 of the switching transistor T1, the first gate electrodes 146 and 148 of the first and third driving transistors T2_SP1 and T2_SP3, and the shielding pattern 147 of the second driving transistor T2_SP2 is made of a conductive metal material. Specifically, the conductive metal material may include at least one of an aluminum-based metal, such as aluminum (Al) or an aluminum alloy, a silver-based metal, such as silver (Ag) or a silver alloy, a copper-based metal, such as copper (Cu) or a copper alloy, a molybdenum-based metal, such as molybdenum (Mo) or a molybdenum alloy, chromium (Cr), tantalum (Ta), neodymium (Nd), and titanium (Ti). More specifically, each of the first storage electrode 144, the gate electrode 145 of the switching transistor T1, the first gate electrodes 146 and 148 of the first and third driving transistors T2_SP1 and T2_SP3, and the shielding pattern 147 of the second driving transistor T2_SP2 may include a stack structure of molybdenum/titanium layers to increase conductivity and may have hydrogen trapping properties.

A sixth insulating layer 126 having a first thickness D1 is provided on the fifth insulating layer 125. the first storage electrode 144, the gate electrode 145 of the switching transistor T1, the first gate electrodes 146 and 148 of the first and third driving transistors T2_SP1 and T2_SP3, and the shielding pattern 147 of the second driving transistor T2_SP2. The sixth insulating layer 126 may include a silicon oxide layer.

The sixth insulating layer 126 may function as a gate insulating layer of the first driving transistor T2_SP1, the third driving transistor T2_SP3, and the switching transistor T1.

The first active layers 152 and 154 of the first and third driving transistors T2_SP1 and T2_SP3, the second active layer 153 of the second driving transistor T2_SP2, and the active layer 151 of the switching transistor T1 may be disposed by depositing an oxide semiconductor material on the sixth insulating layer 126 and selectively removing the same.

The oxide semiconductor material may include a combination of at least one of zinc (Zn), indium (In), gallium (Ga), tin (Sn), and titanium (Ti) and an oxide. In some cases, a highly conductive metal such as iron (Fe) may be further included in the oxide semiconductor material to increase mobility.

Examples of the oxide semiconductor material may include zinc oxide (ZnO), zinc-tin oxide (ZTO), zinc-indium oxide (ZIO), indium oxide (InO), titanium oxide (TiO), indium-gallium-zinc oxide (IGZO), indium-zinc-tin oxide (IZTO), and iron-indium-zinc oxide (FIZO).

The third to sixth insulating layers 123, 124, 125, and 126 may be selectively removed to expose the upper portions of both sides of the third active layer 135 to provide a contact hole.

Fifth and sixth source-drain electrodes 161 and 162 connected to the third active layer 135 may be provided respectively through the contact holes through the third to sixth insulating layers 123, 124, 125, and 126 by depositing a conductive material on the sixth insulating layer 126 and selectively removing the same. At the same layer as the fifth and sixth source-drain electrodes 161 and 162, a second storage electrode 163 overlapping the first storage electrode 144 may be provided, first cover electrodes 166 and 168 and second cover electrodes 167 and 169 respectively abutting the upper surfaces and the side portions of the first active layers 152 and 154 are provided on both sides of the first active layers 152 and 154 of the first and third driving transistors respectively, and source-drain electrodes 164 and 165 abutting the upper surface and the side portion of the active layer 151 of the switching transistor T1 may be provided.

The seventh insulating layer 127 is provided on the fifth and sixth source-drain electrodes 161 and 162 of the third transistor T3, the second storage electrode 163, the first cover electrodes 166 and 168 and the second cover electrodes 167 and 169 of the first and third driving transistors T2_SP1 and T2_SP3, and the source-drain electrodes 164 and 165 of the switching transistor T1. The seventh insulating layer 127 may have a second thickness D2 greater than the first thickness D1 of the sixth insulating layer 126. The seventh insulating layer 127 functions as a gate insulating layer of the second driving transistor T2_SP2.

The second driving transistor T2_SP2 is provided with a second gate electrode 170 overlapping the second active layer 153.

The second gate electrode 170 may include at least one of an aluminum-based metal such as aluminum (Al) or an aluminum alloy, a copper-based metal such as copper (Cu) or a copper alloy, a molybdenum-based metal such as molybdenum (Mo) or a molybdenum alloy, chromium (Cr), tantalum (Ta), neodymium (Nd), and titanium (Ti).

The second gate electrode 170 may have a single layer or multiple layers.

The eighth insulating layer 128 is provided so as to cover the second gate electrode 170.

The seventh and eighth insulating layers 127 and 128 are selectively removed to form first and second contact holes CT1 and CT2 respectively exposing parts of the upper portions of the first cover electrode 166 and the second cover electrode 16 of the first driving transistor T2_SP1, third and fourth contact holes CT3 and CT4 respectively exposing a part of the upper portion of the second active layer 153 of the second driving transistor T2_SP2, and fifth and sixth contact holes CT5 and CT6 respectively exposing parts of the upper portions of the first cover electrode 168 and the second cover electrode 169 of the third driving transistor T2_SP3. See, e.g., FIG. 5.

A conductive material is deposited on the eighth insulating layer 128 and is selectively removed to provide first and second source-drain electrodes 181 and 182 connected respectively to the first and second cover electrodes 166 and 167 of the first driving transistor T2_SP1 respectively through the first and second contact holes CT1 and CT2, third and fourth source-drain electrodes 183 and 184 connected to the second active layer 153 of the second driving transistor T2_SP2 respectively through the third and fourth contact holes CT3 and CT4, and first and second source-drain electrodes 185 and 186 respectively connected to the first and second cover electrodes 168 and 169 of the third driving transistor T2_SP3 respectively through the fifth and sixth contact holes CT5 and CT6. A protective electrode 180 overlapping the active layer 151 of the switching transistor may be provided at the same layer.

Each of the first to fourth source-drain electrodes 181/185, 182/186, 183, and 184 and the protective electrode 180 may include at least one of an aluminum-based metal such as aluminum (Al) or an aluminum alloy, a copper-based metal such as copper (Cu) or a copper alloy, a molybdenum-based metal such as molybdenum (Mo) or a molybdenum alloy, chromium (Cr), tantalum (Ta), neodymium (Nd), and titanium (Ti). Each of the first to fourth source-drain electrodes 181/185, 182/186, 183, and 184 and the protective electrode 180 may have a single layer or multiple layers.

A planarization layer 130 configured to protect each of the transistors T1, T2_SP1, T2_SP2, and T2_SP3, the storage capacitor Cst, and the third transistor T3 may be provided on the first to fourth source-drain electrodes 181/185, 182/186, 183, and 184 and the protective electrode 180.

A display device according to at least one embodiment of the present disclosure may comprise a substrate on which a first subpixel and a second subpixel are disposed, a first driving transistor at the first subpixel, the first driving transistor comprising a first active layer, a first gate electrode under the first active layer, a lower insulating layer between the first active layer and the first gate electrode, and first and second cover electrodes to cover upper and side portions of both edges (e.g., opposite edges) of the first active layer, and a second driving transistor at the second subpixel, the second driving transistor comprising a second active layer, a second gate electrode above the second active layer, and an upper insulating layer between the second active layer and the second gate electrode.

The second subpixel may be configured to emit green light, and the first subpixel may be configured to emit light of a color different from the green light.

In a display device according to at least one embodiment of the present disclosure, a length of a channel area of the first active layer and a length of a channel area of the second active layer may be the same. A width of the channel area of the first active layer and a width of the channel area of the second active layer may be the same.

In a display device according to at least one embodiment of the present disclosure, the first active layer may comprise a first channel area at an area overlapping the first gate electrode. An area of the first active layer not overlapping the first gate electrode at an outside of the first channel area may be in contact with one of the first cover electrode and the second cover electrode.

In a display device according to at least one embodiment of the present disclosure, a first vertical distance between the first active layer and the first gate electrode may be shorter than a second vertical distance between the second active layer and the second gate electrode.

In a display device according to at least one embodiment of the present disclosure, the first driving transistor may comprise a first source-drain electrode connected to the first cover electrode and a second source-drain electrode connected to the second cover electrode. The second driving transistor may comprise a third source-drain electrode and a fourth source-drain electrode connected to both sides (e.g., opposite sides) of the second active layer. The first to fourth source-drain electrodes may be disposed at a same layer.

A display device according to at least one embodiment of the present disclosure may further comprise a first switching transistor at each of the first subpixel and the second subpixel, and a protective electrode overlapping an active layer of the first switching transistor at a same layer as the first source-drain electrode.

A display device according to at least one embodiment of the present disclosure may further comprise a first switching transistor at each of the first subpixel and the second subpixel. The first switching transistor may comprise an active layer at a same layer as the first active layer, a gate electrode under the active layer, the lower insulating layer between the active layer and the gate electrode, and a source-drain electrode to cover upper and side portions of both edges (e.g., opposite edges) of the active layer.

In a display device according to at least one embodiment of the present disclosure, the gate electrode of the first switching transistor may overlap a channel area of the active layer, and the source-drain electrode may overlap and may be directly connected to the active layer with no horizontal separation from the gate electrode.

In a display device according to at least one embodiment of the present disclosure, each of the first active layer, the second active layer, and the active layer may comprise an oxide semiconductor.

In a display device according to at least one embodiment of the present disclosure, each of the first active layer, the second active layer, and the active layer may comprise at least one of IZO (InZnO)-based, IGO (InGaO)-based, ITO (InSnO)-based, IGZO (InGaZnO)-based, IGZTO (InGaZnSnO)-based, GZTO (GaZnSnO)-based, GZO (GaZnO)-based, ITZO (InSnZnO)-based, and FIZO (FeInZnO)-based oxide semiconductor materials.

In a display device according to at least one embodiment of the present disclosure, the first active layer, the second active layer, and the active layer may be disposed at a same layer.

A display device according to at least one embodiment of the present disclosure may further comprise a shielding pattern under the lower insulating layer, the shielding pattern overlapping the second active layer of the second driving transistor.

In a display device according to at least one embodiment of the present disclosure, the first gate electrode, the gate electrode, and the shielding pattern may be disposed at a same layer.

In a display device according to at least one embodiment of the present disclosure, each of the first gate electrode, the gate electrode, and the shielding pattern may comprise a stack of a molybdenum layer and a titanium layer.

A display device according to at least one embodiment of the present disclosure may further comprise a storage capacitor at each of the first subpixel and the second subpixel, the storage capacitor comprising a first storage electrode at a same layer as the first gate electrode, a second storage electrode provided at a same layer as the source-drain electrode, and the lower insulating layer between the first storage electrode and the second storage electrode.

A display device according to at least one embodiment of the present disclosure may further comprise a second switching transistor on the substrate, the second switching transistor comprising a third gate electrode under the first gate electrode, a third active layer under the third gate electrode, a gate insulating layer between the third gate electrode and the third active layer, and fifth and sixth source-drain electrodes connected to both sides (e.g., opposite sides) of the third active layer, the fifth and sixth source-drain electrodes at a same layer as the first cover electrode.

In a display device according to at least one embodiment of the present disclosure, the third active layer may comprise crystalline silicon.

A display device according to at least one embodiment of the present disclosure may further comprise a planarization layer to cover the first and second driving transistors, and a first light emitting device at the first subpixel and a second light emitting device at the second subpixel on the substrate, each of the first and second light emitting devices comprising a first electrode connected to a respective one of the first driving transistor and the second driving transistor, an intermediate layer on the first electrode, and a second electrode on the intermediate layer.

A display device according to at least one embodiment of the present disclosure may further comprise a third subpixel configured to emit light of a different wavelength than each of the first subpixel and the second subpixel. A light emitting wavelength may increase in the order of the first subpixel, the second subpixel, and the third subpixel.

In a display device according to at least one embodiment of the present disclosure, the third subpixel may comprise a third driving transistor having a same structure as the first driving transistor.

The display device according to one or more of the embodiments of the present disclosure may include driving transistors having the same dimensions at subpixels having different emission colors but different stacking structures, whereby the on-current characteristics and S-factor characteristics for each emission color may be different.

As is apparent from the above description, a display device according to at least one embodiment of the present disclosure may include driving transistors having the same dimensions at subpixels having different emission colors but different stacking structures, whereby the on-current characteristics and S-factor characteristics for each emission color may be different.

The display device according to one or more of the embodiments of the present disclosure may have a simplified layout structure by unifying the dimensions of active layers in transistors provided at the subpixels. Thus, mass productivity may be secured and at the same time, the required performance for each emitting color by different stacking structures of different subpixels may be secured.

In the display device according to at least one embodiment of the present disclosure, a cover electrode covering the edge of the active layer may be provided at each of switching transistors, among the transistors provided at the subpixels, thereby reducing the light sensitivity of the switching transistors due to internal light at the display device, thereby improving reliability.

In the display device according to at least one embodiment of the present disclosure, a gate electrode of the switching transistor and a shielding pattern of the driving transistor may be provided at the same layer, realizing mask reduction and process simplification by reducing the number of metal layers required for the display device.

Embodiments of the present disclosure may improve the reliability of the transistors to reduce the defect rate, and have the effect of reducing production energy through process optimization. Furthermore, the use of harmful production materials or regulated substances required for manufacturing the display device may be reduced by reducing the layer structure in the display device, which is more advantageous for recycling and implementing an environmentally friendly display device.

In the display device according to at least one embodiment of the present disclosure, it is possible to reduce the defect rate by preventing deterioration of device reliability and to achieve ESG (environmental/social/governance) goals by reducing production energy through process optimization.

In addition to the above effects, the specific effects of the present disclosure have been described in the detailed description of the disclosure above.

## Claims

1. A display device (1000) comprising:
a substrate (110) on which a first subpixel (SP1) and a second subpixel (SP2) are disposed;
a first driving transistor (T2_SP1) at the first subpixel (SP1), the first driving transistor (T2_SP1) comprising a first active layer (152), a first gate electrode (146) under the first active layer (152), a lower insulating layer (126) between the first active layer (152) and the first gate electrode (146), and first and second cover electrodes (166, 167) to cover upper and side portions of both edges of the first active layer (152); and
a second driving transistor (T2_SP2) at the second subpixel (SP2), the second driving transistor (T2_SP2) comprising a second active layer (153), a second gate electrode (170) above the second active layer (153), and an upper insulating layer (127) between the second active layer (153) and the second gate electrode (170), wherein
the second subpixel (SP2) is configured to emit green light, and
the first subpixel (SP1) is configured to emit light of a color different from the green light.

2. The display device (1000) according to claim 1, wherein
a length (L1) of a channel area (CH1) of the first active layer (152) and a length (L2) of a channel area (CH2) of the second active layer (153) are the same, and
a width (W1) of the channel area (CH1) of the first active layer (152) and a width (W2) of the channel area (CH2) of the second active layer (153) are the same.

3. The display device (1000) according to claim 1 or 2, wherein
the first active layer (152) comprises a first channel area (CH1) at an area overlapping the first gate electrode (146), and
an area (SDA) of the first active layer (152) not overlapping the first gate electrode (146) at an outside of the first channel area (CH1) is in contact with one of the first cover electrode (166) and the second cover electrode (167).

4. The display device (1000) according to any of claims 1 to 3, wherein a first vertical distance (D1) between the first active layer (152) and the first gate electrode (146) is shorter than a second vertical distance (D2) between the second active layer (153) and the second gate electrode (170).

5. The display device (1000) according to any of claims 1 to 4, wherein
the first driving transistor (T2_SP1) comprises a first source-drain electrode (181) connected to the first cover electrode (166) and a second source-drain electrode (182) connected to the second cover electrode (167),
the second driving transistor (T2_SP2) comprises a third source-drain electrode (183) and a fourth source-drain electrode (184) connected to both sides of the second active layer (153), and
the first to fourth source-drain electrodes (181, 182, 183, 184) are disposed at a same layer.

6. The display device (1000) according to claim 5, further comprising:
a first switching transistor (T1_SP1, T1_SP2) at each of the first subpixel (SP1) and the second subpixel (SP2), and
a protective electrode (180) overlapping an active layer (151) of the first switching transistor (T1) at a same layer as the first source-drain electrode (181).

7. The display device (1000) according to any of claims 1 to 5, further comprising a first switching transistor (T1_SP1, T1_SP2) at each of the first subpixel (SP1) and the second subpixel (SP2),
wherein the first switching transistor (T1_SP1, T1_SP2) comprises an active layer (151) at a same layer as the first active layer (152), a gate electrode (145) under the active layer (151), the lower insulating layer (126) between the active layer (151) and the gate electrode (145), and a source-drain electrode (164, 165) to cover upper and side portions of both edges of the active layer (151).

8. The display device (1000) according to claim 7, wherein the gate electrode (145) of the first switching transistor (T1_SP1, T1_SP2) overlaps a channel area of the active layer (151), and the source-drain electrode (164, 165) overlaps and is directly connected to the active layer (151) with no horizontal separation from the gate electrode (145).

9. The display device (1000) according to claim 7 or 8, wherein each of the first active layer (152), the second active layer (153), and the active layer (151) comprises an oxide semiconductor, preferably at least one of IZO (InZnO)-based, IGO (InGaO)-based, ITO (InSnO)-based, IGZO (InGaZnO)-based, IGZTO (InGaZnSnO)-based, GZTO (GaZnSnO)-based, GZO (GaZnO)-based, ITZO (InSnZnO)-based, and FIZO (FeInZnO)-based oxide semiconductor materials.

10. The display device (1000) according to any of claims 7 to 9, wherein the first active layer (152), the second active layer (153), and the active layer (151) are disposed at a same layer.

11. The display device (1000) according to any of claims 7 to 10, further comprising a shielding pattern (147) under the lower insulating layer (126), the shielding pattern (147) overlapping the second active layer (153) of the second driving transistor (T2_SP2).

12. The display device (1000) according to claim 11, wherein the first gate electrode (146), the gate electrode (145), and the shielding pattern (147) are disposed at a same layer, and/or
wherein each of the first gate electrode (146), the gate electrode (145), and the shielding pattern (147) comprises a stack of a molybdenum layer and a titanium layer.

13. The display device (1000) according to any of claims 7 to 12, further comprising a storage capacitor (Cst) at each of the first subpixel (SP1) and the second subpixel (SP2), the storage capacitor (Cst) comprising a first storage electrode (144) at a same layer as the first gate electrode (146), a second storage electrode (163) provided at a same layer as the source-drain electrode (164, 165), and the lower insulating layer (126) between the first storage electrode (144) and the second storage electrode (163).

14. The display device (1000) according to any of claims 1 to 13, further comprising a second switching transistor (T3) on the substrate (110), the second switching transistor (T3) comprising a third gate electrode (140) under the first gate electrode (146), a third active layer (135) under the third gate electrode (140), a gate insulating layer (123) between the third gate electrode (140) and the third active layer (135), and fifth and sixth source-drain electrodes (161, 162) connected to both sides of the third active layer (135), the fifth and sixth source-drain electrodes (161, 162) at a same layer as the first cover electrode (166),
wherein, preferably, the third active layer (135) comprises crystalline silicon.

15. The display device (1000) according to any of claims 1 to 14, further comprising a planarization layer (130) to cover the first and second driving transistors (T2_SP1, T2_SP2), and a first light emitting device (190) at the first subpixel (SP1) and a second light emitting device (190) at the second subpixel (SP2) on the substrate (110), each of the first and second light emitting devices (190) comprising a first electrode (191a, 191b) connected to a respective one of the first driving transistor (T2_SP1) and the second driving transistor (T2_SP2), an intermediate layer (192) on the first electrode (191a, 191b), and a second electrode (193) on the intermediate layer (192); and/or
the display device (1000) further comprising:
a third subpixel (SP3) configured to emit light of a different wavelength than each of the first subpixel (SP1) and the second subpixel (SP2), wherein
a light emitting wavelength increases in the order of the first subpixel (SP1), the second subpixel (SP2), and the third subpixel (SP3),
wherein, preferably, the third subpixel (SP3) comprises a third driving transistor (T2_SP3) having a same structure as the first driving transistor (T2_SP1).
